# DEMANDE DE BREVET EUROPEEN

(11) **EP 3 872 843 A1**
(43) Date de publication de la demande: **01.09.2021**
(21) Numéro de dépôt: 21158347.1
(22) Date de dépôt: 22.02.2021
(51) Int. Cl.: H01L 21/331, H01L 29/10, H01L 29/737, H01L 29/732

(54) **PROCÉDÉ DE FABRICATION D'UN TRANSISTOR BIPOLAIRE ET TRANSISTOR BIPOLAIRE SUSCEPTIBLE D'ÊTRE OBTENU PAR UN TEL PROCÉDÉ**

(30) Priorité: 28.02.2020 FR 2001986
(71) Demandeur: STMicroelectronics Crolles 2 SAS, 38920 Crolles (FR)
(72) Inventeur: BREZZA, Edoardo, 38000 GRENOBLE (FR); GAUTHIER, Alexis, 38240 MEYLAN (FR); DEPRAT, Fabien, 73000 CHAMBERY (FR); CHEVALIER, Pascal, 38530 CHAPAREILLAN (FR)
(74) Mandataire: Cabinet Beaumont

(57) **Abrégé**

Le présent texte concerne un procédé de fabrication d'un transistor bipolaire, comprenant :
- formation d'un empilement (2) comprenant successivement quatre couches (21, 22, ,23, 24), dans lequel chacune des première à quatrième couches est apte à être gravée sélectivement par rapport à chaque couche adjacente, les première, deuxième et quatrième couche étant électriquement isolantes,
- formation d'une ouverture / fenêtre (20) dans l' empilement jusqu'au substrat,
- formation par épitaxie du collecteur (C) et formation par gravure sélective d'une ouverture annulaire (230) dans la troisième couche (23),
- formation par épitaxie d'une base intrinsèque (B1), séparée de la troisième couche (23) par une lame d'air (3) formée dans l'ouverture annulaire (230),
- formation de l'émetteur (E) sur la base intrinsèque,
- gravure sélective de la troisième couche (23),
- dépôt sélectif d'une couche semi-conductrice (30) sur la deuxième couche (22), en contact direct avec la partie intrinsèque, de sorte à former une base extrinsèque (B2).

## Description

### Domaine technique

Le présent texte concerne un procédé de fabrication d'un transistor bipolaire et un transistor bipolaire susceptible d'être obtenu par un tel procédé.

### Technique antérieure

Un transistor bipolaire comprend un émetteur, une base et un collecteur superposés sur un substrat semi-conducteur.

La base comprend une partie dite intrinsèque, qui est la région active du transistor, formant une jonction avec le collecteur au niveau de sa partie inférieure et avec l'émetteur au niveau de sa partie supérieure, et une partie dite extrinsèque, qui est une région de connexion électrique s'étendant latéralement par rapport à la base intrinsèque, par l'intermédiaire de laquelle la partie intrinsèque peut être polarisée lors du fonctionnement du transistor.

Pour réduire la capacité base-collecteur, il est souhaitable d'isoler électriquement le collecteur de la partie extrinsèque de la base.

Une telle isolation peut être réalisée au moyen d'une lame d'air entourant la jonction base-collecteur, permettant d'éviter tout contact entre la partie extrinsèque de la base et le collecteur.

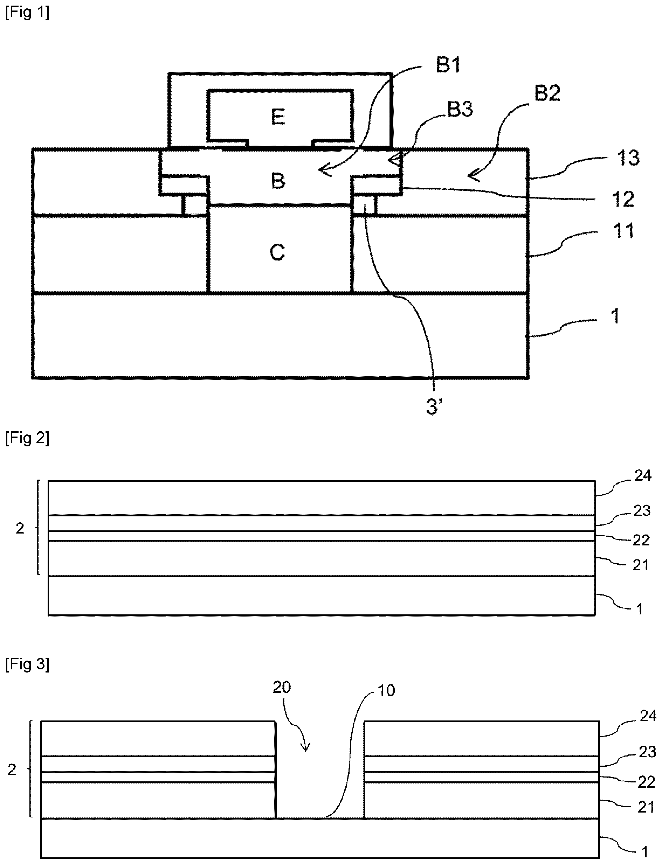

La figure 1 illustre un transistor bipolaire formé sur un substrat semi-conducteur 1. Le collecteur C est formé en partie dans une couche électriquement isolante 11. La partie supérieure du collecteur C, qui forme une jonction avec la partie intrinsèque B1 de la base B, est entourée d'une lame d'air 3'. La partie intrinsèque B1 est connectée à une couche semi-conductrice 13 qui forme la partie extrinsèque B2 de la base par une portion latérale B3, qui est formée postérieurement à la partie B1 et présente des propriétés électriques différentes. La lame d'air 3' est délimitée par la couche électriquement isolante 11, la couche semi-conductrice 13 et une couche 12 électriquement isolante s'étendant sous la tête du T de la partie intrinsèque de la base.

Les documents US 10,186,605 et US 10,224,423 décrivent des procédés permettant de former une telle lame d'air.

Cependant, ces procédés sont particulièrement complexes du fait du nombre d'étapes à mettre en œuvre pour relier la partie extrinsèque à la partie intrinsèque de la base. De plus, il est difficile de maîtriser les dimensions de la lame d'air, ce qui engendre des risques de court-circuit entre la partie extrinsèque de la base et le collecteur.

### Résumé de l'invention

Il subsiste donc un besoin de concevoir un procédé de fabrication d'un transistor bipolaire qui permette d'isoler électriquement la partie extrinsèque de la base vis-à-vis du collecteur, de manière robuste et avec un nombre minimal d'étapes.

Un objet du présent texte est un procédé de fabrication d'un transistor bipolaire comprenant un collecteur, une base et un émetteur, comprenant :
- la formation, sur un substrat semi-conducteur, d'un empilement comprenant successivement : une première couche, une deuxième couche, une troisième couche et une quatrième couche, dans lequel chacune des première à quatrième couches est apte à être gravée sélectivement par rapport à chaque couche adjacente, les première, deuxième et quatrième couche étant électriquement isolantes,
- la formation d'une ouverture dans l'empilement jusqu'au substrat,
- la formation par épitaxie sur le substrat du collecteur du transistor bipolaire et la formation par gravure sélective d'une ouverture annulaire dans la troisième couche,
- la formation par épitaxie sur le collecteur d'une partie intrinsèque de la base, ladite partie intrinsèque étant séparée de la troisième couche par une lame d'air formée dans l'ouverture annulaire, la jonction entre le collecteur et la partie intrinsèque de la base étant entourée par la deuxième couche,
- la formation de l'émetteur sur la partie intrinsèque de la base,
- le retrait de la troisième couche par gravure sélective,
- le dépôt sélectif d'une couche semi-conductrice sur la deuxième couche, en contact direct avec la partie intrinsèque de la base, de sorte à former une partie extrinsèque de la base du transistor bipolaire.

Par « partie intrinsèque de la base », on entend dans le présent texte la portion du transistor bipolaire qui forme une jonction P-N respectivement avec le collecteur et avec l'émetteur. Par « partie extrinsèque de la base », on entend dans le présent texte une région de contact électrique s'étendant latéralement par rapport à la partie intrinsèque de la base, dont la fonction est ainsi de polariser la base du transistor bipolaire.

Dans certains modes de réalisation, la formation de l'émetteur comprend la formation d'une ouverture dans la quatrième couche jusqu'à la partie intrinsèque de la base et un dépôt non sélectif d'un matériau semi-conducteur sur la quatrième couche et sur la partie intrinsèque de la base.

Dans certains modes de réalisation, la formation de la partie extrinsèque de la base comprend une première phase de croissance de la couche semi-conductrice latéralement à partir d'un bord de la partie intrinsèque de la base, suivie d'une seconde phase de croissance de la couche semi-conductrice à partir de la surface de la deuxième couche électriquement isolante dans une direction perpendiculaire à ladite surface.

Dans d'autres modes de réalisation, la formation de la partie extrinsèque de la base comprend une phase de dépôt d'une première couche semi-conductrice sur la deuxième couche électriquement isolante suivie du dépôt sélectif de la couche semi-conductrice sur ladite première couche semi-conductrice.

Dans certains modes de réalisation, les première, deuxième et quatrième couches sont formées d'un matériau choisi parmi l'oxyde de silicium (SiO2) et le nitrure de silicium (Si3N4).

En particulier, les première et quatrième couches peuvent être des couches d'oxyde de silicium et la deuxième couche peut être une couche de nitrure de silicium.

Dans certains modes de réalisation, la troisième couche est une couche de silicium-germanium polycristallin.

Dans certains modes de réalisation, la couche semi-conductrice formant la partie extrinsèque de la base est une couche de silicium polycristallin.

Dans certains modes de réalisation, la partie intrinsèque de la base comprend du silicium-germanium.

Dans certains modes de réalisation, la troisième couche et la partie intrinsèque de la base sont en silicium-germanium et la teneur en germanium de la troisième couche est au moins 1,5 fois plus grande que la teneur en germanium de la partie intrinsèque de la base.

Dans certains modes de réalisation, le procédé comprend, avant la formation de l'émetteur, la formation d'espaceurs sur la partie intrinsèque de la base.

En particulier, la formation des espaceurs peut comprendre :
- le dépôt d'une couche d'oxyde de silicium sur la partie intrinsèque de la base,
- le dépôt d'une couche de nitrure de silicium sur la couche d'oxyde de silicium,
- la formation d'une ouverture dans lesdites couches de nitrure de silicium et d'oxyde de silicium jusqu'à la partie intrinsèque de la base, de sorte à délimiter lesdits espaceurs dans la couche d'oxyde de silicium.

Un autre objet concerne une structure comprenant un transistor bipolaire susceptible d'être obtenu par le procédé décrit plus haut.

Ladite structure comprend un transistor bipolaire incluant un collecteur, une base et un émetteur, ladite structure comprenant :
- un substrat semi-conducteur,
- un empilement comprenant successivement à partir du substrat : une première couche électriquement isolante, une seconde couche électriquement isolante en un matériau différent de celui de la première couche électriquement isolante et une couche semi-conductrice, ledit empilement comprenant une fenêtre s'étendant jusqu'au substrat,
- le collecteur, une partie intrinsèque de la base et l'émetteur étant empilés successivement sur le substrat dans ladite fenêtre, la jonction entre le collecteur et la partie intrinsèque de la base étant entourée par la seconde couche électriquement isolante, la couche semi-conductrice formant une partie extrinsèque de la base du transistor bipolaire.

Dans certains modes de réalisation, la deuxième couche électriquement isolante est située sur et en contact avec la première couche électriquement isolante.

Dans certains modes de réalisation, la seconde couche électriquement isolante est en contact direct avec la jonction entre le collecteur et la partie intrinsèque de la base.

Dans certains modes de réalisation, la première couche électriquement isolante est en oxyde de silicium et la seconde couche électriquement isolante est en nitrure de silicium.

Dans certains modes de réalisation, la couche semi-conductrice formant la partie extrinsèque de la base est en silicium polycristallin.

### Brève description des dessins

D'autres caractéristiques et avantages de ces modes de réalisation apparaîtront dans la description détaillée qui va suivre, en référence aux dessins annexés sur lesquels :
la figure 1 est une vue schématique en coupe d'un transistor bipolaire comprenant une lame d'air autour de la jonction entre la base et le collecteur ;
la figure 2 est une vue schématique en coupe d'un empilement de couches formé sur un substrat ;
la figure 3 est une vue schématique en coupe de la structure de la figure 2 après formation d'une ouverture dans l'empilement ;
la figure 4 est une vue schématique en coupe de la structure de la figure 3 après formation par épitaxie du collecteur d'un transistor bipolaire sur le substrat ;
la figure 5 est une vue schématique en coupe de la structure de la figure 4 après formation par épitaxie de la base du transistor bipolaire sur le collecteur ;
la figure 6 est une vue schématique en coupe de la structure de la figure 5 après dépôt d'une couche d'oxyde de silicium et de nitrure de silicium ;
la figure 7 est une vue schématique en coupe de la structure de la figure 6 après gravure d'une partie de la couche de nitrure de silicium ;
la figure 8 est une vue schématique en coupe de la structure de la figure 7 après formation d'une ouverture exposant la surface supérieure de la base du transistor bipolaire ;
la figure 9 est une vue schématique en coupe de la structure de la figure 8 après retrait de plots de nitrure de silicium ;
la figure 10 est une vue schématique en coupe de la structure de la figure 9 après dépôt du matériau formant l'émetteur du transistor bipolaire et d'une couche protectrice ;
la figure 11 est une vue schématique en coupe de la structure de la figure 10 après délimitation de l'émetteur du transistor bipolaire ;
la figure 12 est une vue schématique en coupe de la structure de la figure 11 après dépôt d'une couche d'encapsulation autour de l'émetteur ;
la figure 13 est une vue schématique en coupe de la structure de la figure 12 après gravure localisée de la couche d'encapsulation ;
la figure 14 est une vue schématique en coupe de la structure de la figure 13 après retrait de la couche de silicium-germanium polycristallin ;
la figure 15 est une vue schématique en coupe de la structure de la figure 14 après dépôt sélectif d'une couche semi-conductrice formant la partie extrinsèque de la base du transistor bipolaire ;
la figure 16a est une vue schématique en coupe des étapes dudit dépôt sélectif selon un premier mode de réalisation ; et
la figure 16b est une vue schématique en coupe des étapes dudit dépôt sélectif selon un second mode de réalisation.

Pour des raisons de lisibilité des figures, les dessins ne sont pas tracés à l'échelle. Par ailleurs, les dessins ont été simplifiés de sorte à ne faire apparaître que les éléments utiles à la compréhension des figures.

Dans le présent texte, les termes « latéral », « inférieur », « supérieur », « sous », « sur », « au dessus », « en dessous », etc. s'entendent par rapport à l'orientation des éléments considérés sur les figures.

### Description des modes de réalisation

En référence à la figure 2, on a formé sur un substrat 1 un empilement 2 des quatre couches successives suivantes :
- une première couche 21,
- une deuxième couche 22,
- une troisième couche 23,
- une quatrième couche 24.

La deuxième couche 22 est située sur et en contact avec la première couche 21.

Le substrat 1 est un substrat semi-conducteur monocristallin, éventuellement dopé. Par exemple, le substrat 1 peut être un substrat de silicium monocristallin. Comme cela sera décrit plus bas, le substrat 1 doit en effet servir de germe à la croissance épitaxiale du collecteur, de la base et de l'émetteur d'un transistor bipolaire.

La première, la deuxième et la quatrième couche de l'empilement sont électriquement isolantes. Par exemple, lesdites couches peuvent être formées d'oxyde de silicium (SiO2) ou de nitrure de silicium (Si3N4).

Par ailleurs, chacune des couches 21 à 24 est apte à être gravée sélectivement par rapport à chaque couche adjacente.

Ainsi, dans certains modes de réalisation, les couches 21 et 24 sont des couches d'oxyde de silicium et la couche 22 une couche de nitrure de silicium.

La troisième couche 23 est avantageusement une couche de silicium-germanium polycristallin, qui est apte à être gravée sélectivement par rapport aux couches 22 et 24 et par rapport au matériau de la partie intrinsèque de la base qui sera formée ultérieurement.

Naturellement, ces matériaux sont donnés à titre d'exemples et l'homme du métier pourra choisir d'autres matériaux remplissant les conditions mentionnées ci-dessus.

En référence à la figure 3, on a formé dans l'empilement 2 une ouverture 20 s'étendant jusqu'au substrat 1, de sorte à exposer la surface 10 du substrat 1.

Une telle ouverture peut être formée par gravure au travers d'un masque (non représenté), notamment par gravure sèche. La gravure met en œuvre des agents de composition adaptée pour graver successivement les couches 24, 23, 22 et 21. Cette gravure est essentiellement anisotrope, c'est-à-dire principalement dans le sens de l'épaisseur de l'empilement. Le choix des agents de gravure en fonction des matériaux à graver est à la portée de l'homme du métier et ne sera pas détaillé dans le présent texte.

L'ouverture 20 forme une fenêtre dans laquelle le collecteur, la base et l'émetteur doivent être formés à partir de la surface 10 du substrat 1.

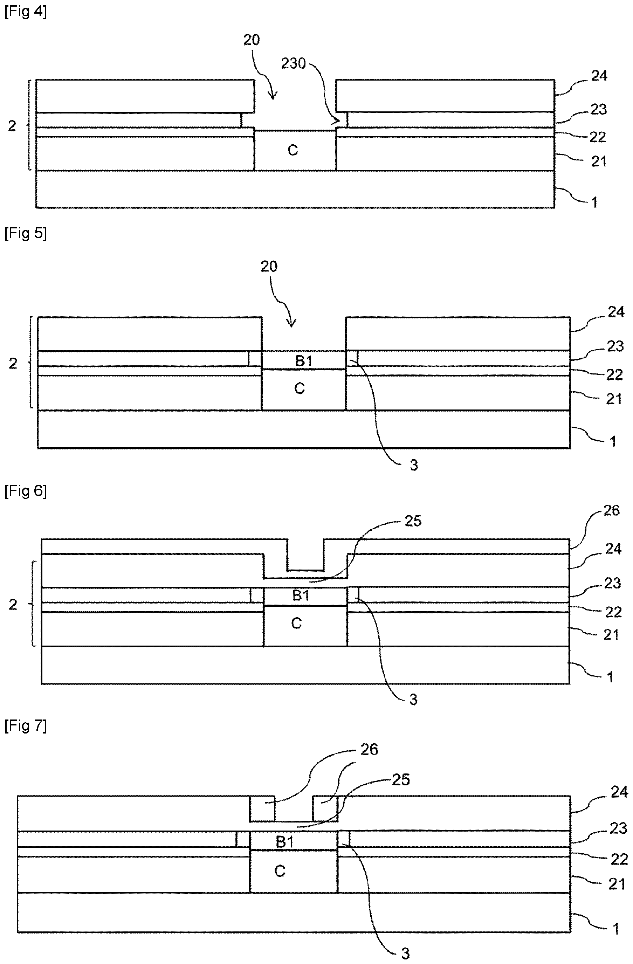

En référence à la figure 4, on a mis en œuvre un procédé d'épitaxie sélective cyclique pour faire croître le collecteur C du transistor bipolaire tout en gravant latéralement la couche 23.

Le substrat 1 qui est monocristallin sert de germe à la croissance épitaxiale du collecteur. Le collecteur est formé d'un matériau semi-conducteur monocristallin dont le paramètre de maille est aussi proche que possible du paramètre de maille du substrat 1 afin d'éviter la génération de défauts cristallins dans le collecteur. De manière avantageuse, le substrat 1 et le collecteur C sont tous deux en silicium monocristallin. Le collecteur C peut être dopé pendant ou après l'épitaxie, par des moyens connus de l'homme du métier. Dans le cas d'un transistor NPN, le dopage du collecteur peut être réalisé avec de l'arsenic ou du phosphore, avec une dose typiquement de l'ordre de 1018 à 1019 cm-3. Dans le cas d'un transistor PNP, le dopage du collecteur peut être réalisé avec du bore ou de l'indium, avec une dose typiquement de l'ordre de 1018 à 1019 cm-3.

Chaque cycle d'épitaxie sélective comprend une étape de gravure et une étape de croissance. La vitesse de croissance est différente selon le matériau à partir duquel la croissance est mise en œuvre. La sélectivité de l'épitaxie est procurée par la gravure qui permet d'éliminer le matériau déposé là où la croissance est moins rapide.

Chaque étape de gravure sélective met en œuvre un agent de gravure qui grave plus rapidement le silicium-germanium polycristallin de la couche 23 que le silicium du collecteur. Par exemple, l'agent de gravure comprend de l'acide chlorhydrique (HCl). Chaque étape de gravure sélective permet de former une ouverture annulaire 230 s'étendant latéralement autour de l'ouverture 20 dans la couche 23. La largeur de ladite ouverture 230 est de l'ordre de quelques dizaines de nanomètres de chaque côté de l'ouverture 20.

Chaque étape d'épitaxie sélective permet de faire croître préférentiellement le silicium monocristallin sur la surface 10 du substrat 1, le réseau cristallin du substrat 1 servant de germe à la croissance du collecteur C.

La croissance du collecteur est stoppée lorsque la surface supérieure du collecteur est située entre la surface supérieure de la couche 21 d'oxyde de silicium et la surface supérieure de la couche 22 de nitrure de silicium.

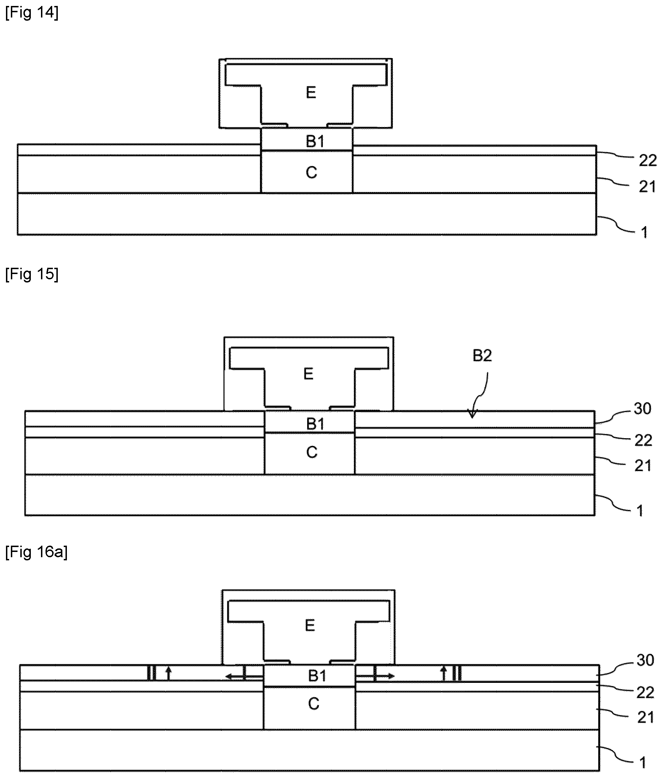

En référence à la figure 5, on a poursuivi l'épitaxie pour faire croître la base du transistor bipolaire (plus précisément, la partie intrinsèque B1 de la base) sur le collecteur C. Le collecteur qui est monocristallin sert de germe à la croissance épitaxiale de la base. La base est formée d'un matériau semi-conducteur monocristallin dont le paramètre de maille est aussi proche que possible du paramètre de maille du collecteur C afin d'éviter la génération de défauts cristallins dans le collecteur. De manière avantageuse, le substrat 1 et le collecteur C sont en silicium monocristallin, tandis que la base B1 est en silicium-germanium monocristallin. La teneur en germanium de la couche 23 est suffisamment grande par rapport à la teneur en germanium de la base B1 (par exemple, plus de 1,5 fois plus grande) pour assurer une sélectivité de la gravure de la couche 23 vis-à-vis de la base B1, afin de ne pas endommager la base lors de la gravure de la couche 23 (étape schématisée sur la figure 14). La base est dopée de type opposé à celui du collecteur pour former une jonction P-N, qui est en contact latéralement avec la couche électriquement isolante 22.

Grâce à l'ouverture annulaire 230 formée dans la couche 23, la base croît uniquement à partir du matériau monocristallin du collecteur, à distance du matériau polycristallin de la couche 23, ce qui permet d'optimiser la qualité cristalline de la base. En effet, si la base était en contact avec la couche 23, le matériau de la base se déposerait également sur le bord de cette couche, qui est constituée d'un matériau différent de celui de la base et qui n'est pas monocristallin, ce qui induirait des défauts cristallins dans la base.

La croissance de la base est stoppée lorsque la surface supérieure de la base atteint la surface supérieure de la couche 23 de silicium-germanium polycristallin.

A l'issue de la croissance de la base, l'ouverture annulaire 230 est donc délimitée intérieurement par la base pour former une lame d'air 3. On notera cependant que cette lame d'air n'est pas située au même emplacement que la lame d'air 3' dans le transistor bipolaire de la figure 1, et qu'elle ne remplit pas la même fonction. En effet, alors que la lame d'air 3' du transistor bipolaire de la figure 1 était destinée à éviter un contact électrique entre la jonction base-collecteur et la partie extrinsèque de la base, la lame d'air 3 de la figure 5 est destinée à optimiser la qualité cristalline de la partie intrinsèque de la base. Comme on le verra plus bas, la lame d'air 3 disparaîtra dans une étape ultérieure du procédé de fabrication du transistor bipolaire et ne sera donc pas présente dans le transistor bipolaire final.

En référence à la figure 6, on a déposé sur la structure de la figure 5 une couche additionnelle 25 d'oxyde de silicium et une couche 26 de nitrure de silicium sur la couche 25 d'oxyde de silicium. Ces deux couches sont destinées à former les espaceurs de l'émetteur qui sera formé par la suite. Le dépôt d'oxyde de silicium étant conforme, il permet de former une couche d'épaisseur uniforme sur toute la surface exposée, ce qui permet d'obtenir ensuite des espaceurs présentant une forme optimale.

En référence à la figure 7, on a gravé la couche 26 de nitrure de silicium sur l'ensemble de la surface de la structure. A l'issue de cette étape de gravure, il ne subsiste que deux plots 26a de nitrure de silicium dans l'ouverture.

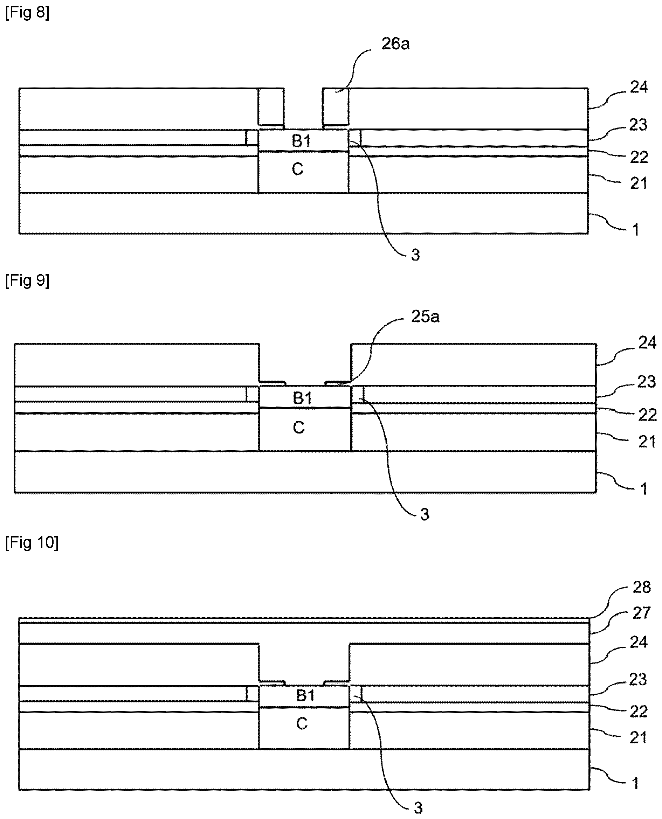

En référence à la figure 8, on a formé une ouverture entre les plots 26a en retirant la couche d'oxyde présente entre lesdits plots, afin d'exposer la surface supérieure de la partie intrinsèque B1 de la base.

En référence à la figure 9, on a retiré les plots de nitrure de silicium 26a, de sorte qu'il ne reste plus sur la partie intrinsèque B1 de la base que deux espaceurs 25a qui sont les portions résiduelles de la couche 25 d'oxyde de silicium.

En référence à la figure 10, on a mis en œuvre un dépôt de silicium polycristallin destiné à former l'émetteur. Ce dépôt n'étant pas sélectif, la couche 27 de silicium polycristallin a été déposée à la fois sur la couche d'oxyde de silicium 24, sur les espaceurs 25a et sur la partie intrinsèque B1 de la base. La couche 27 est dopée de type opposé à celui de la base, pour former une jonction P-N entre la base et l'émetteur. Dans le cas d'un transistor NPN, le dopage de l'émetteur peut être réalisé avec de l'arsenic, avec une dose typiquement de l'ordre de 1020 à 1021 cm-3. Dans le cas d'un transistor PNP, le dopage de l'émetteur peut être réalisé avec du bore, avec une dose typiquement de l'ordre de 1020 à 1021 cm-3.

La couche 27 a ensuite été recouverte d'une couche protectrice 28 électriquement isolante, par exemple en oxyde de silicium.

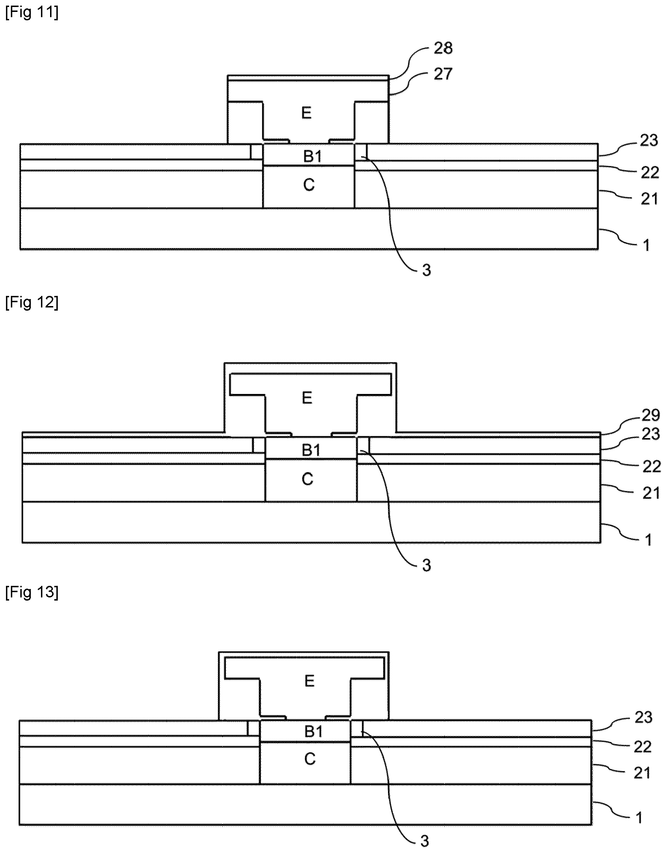

En référence à la figure 11, on a mis en œuvre une gravure au travers d'un masque localisé (non représenté) pour définir l'émetteur E dans la couche 27 de silicium polycristallin. Dans les régions de la structure non recouvertes par le masque, la gravure a retiré la couche 28 d'oxyde de silicium, la couche 27 de silicium polycristallin et la couche 24 d'oxyde de silicium.

L'agent de gravure est choisi pour assurer une gravure de l'oxyde de silicium sélective par rapport au silicium-germanium polycristallin, la couche 23 de silicium-germanium polycristallin servant de couche d'arrêt de gravure.

En référence à la figure 12, on a déposé une couche 29 d'oxyde de silicium permettant d'encapsuler l'émetteur. Ladite couche 29 est déposée de manière conforme sur la couche 23 de silicium-germanium polycristallin, sur la couche 28 d'oxyde de silicium et sur les bords latéraux de l'émetteur.

En référence à la figure 13, on a gravé la couche 29 d'oxyde de silicium présente sur la surface de la couche 23 de silicium-germanium. Ladite gravure est anisotrope, de sorte à préserver l'oxyde de silicium encapsulant la surface supérieure et les bords latéraux de l'émetteur E. La couche 23 de silicium-germanium polycristallin sert de couche d'arrêt de gravure.

En référence à la figure 14, on a mis en œuvre une gravure de la couche 23 de silicium-germanium polycristallin. L'agent de gravure est choisi pour assurer une gravure du silicium-germanium polycristallin sélective par rapport aux autres matériaux de la structure, notamment par rapport au matériau de la partie intrinsèque B1 de la base et du matériau de la couche 22.

Cette gravure expose la partie supérieure des bords latéraux de la partie intrinsèque B1 de la base, la jonction base-collecteur étant entourée par la couche 22 de nitrure de silicium.

En référence à la figure 15, on a déposé une couche semi-conductrice 30 sur la couche 22 de nitrure de silicium. Le matériau semi-conducteur de la couche 30 est choisi pour se déposer sélectivement sur le nitrure de silicium, et non sur l'oxyde de silicium. Le nitrure de silicium n'étant pas un matériau monocristallin, le matériau semi-conducteur de la couche 30 est typiquement polycristallin. Selon un mode de réalisation préféré, le matériau de la couche 30 est du silicium polycristallin dopé du même type que la base.

Le dépôt de la couche 30 peut être stoppé à partir du moment où la surface supérieure de ladite couche a atteint la surface inférieure de l'émetteur E. Ainsi, la couche 30 comble entièrement la région en retrait sous l'émetteur, et est en contact électrique avec la partie supérieure de la base B. La couche 30 remplit ainsi la fonction de partie extrinsèque B2 de la base.

Selon un mode de réalisation, illustré sur la figure 16a, la croissance de la couche 30 peut être réalisée d'abord à partir des bords exposés de la partie intrinsèque B1 de la base, dans une direction parallèle à la surface principale de la structure (direction représentée par la flèche I), puis à partir de la surface de la couche 22 de la couche de nitrure de silicium, dans la direction perpendiculaire à la surface de la couche 22 (direction représentée par la flèche II). A cet effet, on met en œuvre dans un premier temps une épitaxie sélective permettant une croissance du matériau de la couche 30 uniquement à partir du silicium-germanium de la partie intrinsèque de la base, puis une épitaxie sélective permettant une croissance du matériau de la couche 30 également à partir du nitrure de silicium de la couche 22.

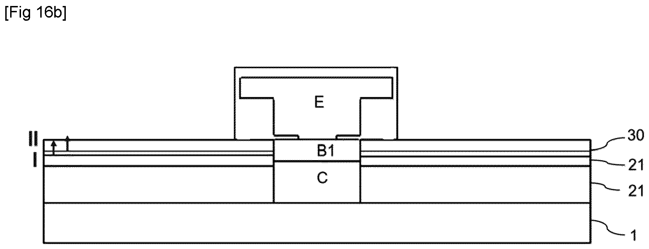

Selon un mode de réalisation alternatif, illustré sur la figure 16b, la croissance de la couche 30 peut être réalisée en deux étapes dans la direction perpendiculaire à la surface principale de la structure. Dans une première étape (schématisée par la flèche I), une fine couche de silicium peut d'abord être déposée sur la couche 22. Dans une seconde étape (schématisée par la flèche II), le silicium polycristallin dopé P est déposé sur la fine couche de silicium pour former le reste de la couche 30. Le dépôt préalable d'une telle fine couche de silicium peut être avantageux pour assurer une sélectivité suffisante du dépôt de la couche de silicium polycristallin vis-à-vis de l'oxyde encapsulant l'émetteur. Compte tenu de sa faible épaisseur, la couche de silicium déposée dans la première étape ne remplit pas de fonction électrique. La fonction électrique de la partie extrinsèque B2 de la base est assurée par la couche de silicium polycristallin déposée dans la deuxième étape.

Ainsi, grâce au choix judicieux des matériaux formant l'empilement déposé sur le substrat en termes de sélectivité de gravure et/ou de dépôt, le procédé décrit dans le présent texte présente les avantages suivants par rapport au procédé de fabrication du transistor bipolaire de la figure 1. D'une part, la lame d'air formée autour de la partie intrinsèque de la base permet d'améliorer la qualité cristalline de la base. D'autre part, l'isolation électrique de la jonction base - collecteur vis-à-vis de la partie extrinsèque de la base est assurée par une couche électriquement isolante (à savoir la couche 22 de nitrure de silicium dans le mode de réalisation illustré sur les figures), qui est en contact direct avec la base et le collecteur de part et d'autre de ladite jonction ; les difficultés liées à la maîtrise d'une lame d'air sont donc évitées. Enfin, le nombre d'étapes mises en œuvre est réduit, notamment en ce qui concerne la réalisation de la connexion entre la partie intrinsèque et la partie extrinsèque de la base.

Le transistor bipolaire ainsi obtenu est donc plus robuste tout en étant plus facile à fabriquer à l'échelle industrielle.

Par ailleurs, les étapes mises en œuvre pour la fabrication dudit transistor bipolaire étant compatibles avec les étapes de fabrication de transistors CMOS, ce procédé se prête bien à la co-intégration de transistors bipolaires et CMOS (désignée par le terme BiCMOS).

## Revendications

1. Procédé de fabrication d'un transistor bipolaire comprenant un collecteur, une base et un émetteur, comprenant :
- la formation, sur un substrat (1) semi-conducteur, d'un empilement (2) comprenant successivement : une première couche (21), une deuxième couche (22), une troisième couche (23) et une quatrième couche (24), dans lequel chacune des première à quatrième couches est apte à être gravée sélectivement par rapport à chaque couche adjacente, les première, deuxième et quatrième couches étant électriquement isolantes,
- la formation d'une ouverture (20) dans l'empilement (2) jusqu'au substrat (1),
- la formation par épitaxie sur le substrat (1) du collecteur (C) du transistor bipolaire et la formation par gravure sélective d'une ouverture annulaire (230) dans la troisième couche (23),
- la formation par épitaxie sur le collecteur (C) d'une partie intrinsèque (B1) de la base, ladite partie intrinsèque (B1) étant séparée de la troisième couche (23) par une lame d'air (3) formée dans l'ouverture annulaire (230), la jonction entre le collecteur (C) et la partie intrinsèque (B1) de la base étant entourée par la deuxième couche (22),
- la formation de l'émetteur (E) sur la partie intrinsèque (B1) de la base,
- le retrait de la troisième couche (23) par gravure sélective,
- le dépôt sélectif d'une couche semi-conductrice (30) sur la deuxième couche (22), en contact direct avec la partie intrinsèque (B1) de la base, de sorte à former une partie extrinsèque (B2) de la base du transistor bipolaire.

2. Procédé selon la revendication 1, dans lequel la formation de l'émetteur comprend la formation d'une ouverture dans la quatrième couche (24) jusqu'à la partie intrinsèque (B1) de la base et un dépôt non sélectif d'un matériau semi-conducteur sur la quatrième couche (24) et sur la partie intrinsèque (B1) de la base.

3. Procédé selon l'une des revendications 1 ou 2, dans lequel la formation de la partie extrinsèque (B2) de la base comprend une première phase de croissance de la couche semi-conductrice (30) latéralement à partir d'un bord de la partie intrinsèque (B1) de la base, suivie d'une seconde phase de croissance de la couche semi-conductrice (30) à partir de la surface de la deuxième couche (22) électriquement isolante dans une direction perpendiculaire à ladite surface.

4. Procédé selon l'une des revendications 1 ou 2, dans lequel la formation de la partie extrinsèque (B2) de la base comprend une phase de dépôt d'une première couche semi-conductrice sur la deuxième couche (22) électriquement isolante suivie du dépôt sélectif de la couche semi-conductrice (30) sur ladite première couche semi-conductrice.

5. Procédé selon l'une des revendications 1 à 4, dans lequel les première, deuxième et quatrième couches (21, 22, 24) sont formées d'un matériau choisi parmi l'oxyde de silicium (SiO2) et le nitrure de silicium (Si3N4).

6. Procédé selon la revendication 5, dans lequel les première et quatrième couches (21, 24) sont des couches d'oxyde de silicium et la deuxième couche (22) est une couche de nitrure de silicium.

7. Procédé selon l'une des revendications 1 à 6, dans lequel la troisième couche (23) est une couche de silicium-germanium polycristallin.

8. Procédé selon l'une des revendications 1 à 7, dans lequel la couche semi-conductrice (30) formant la partie extrinsèque (B2) de la base est une couche de silicium polycristallin.

9. Procédé selon l'une des revendications 1 à 8, dans lequel la partie intrinsèque (B1) de la base comprend du silicium-germanium.

10. Procédé selon la revendication 9 en combinaison avec la revendication 7, dans lequel la teneur en germanium de la troisième couche (23) est au moins 1,5 fois plus grande que la teneur en germanium de la partie intrinsèque (B1) de la base.

11. Procédé selon l'une des revendications 1 à 10, comprenant, avant la formation de l'émetteur (E), la formation d'espaceurs (25a) sur la partie intrinsèque (B1) de la base.

12. Procédé selon la revendication 11, dans lequel la formation des espaceurs comprend :
- le dépôt d'une couche (25) d'oxyde de silicium sur la partie intrinsèque (B1) de la base,
- le dépôt d'une couche (26) de nitrure de silicium sur la couche (25) d'oxyde de silicium,
- la formation d'une ouverture dans lesdites couches (26, 25) de nitrure de silicium et d'oxyde de silicium jusqu'à la partie intrinsèque de la base, de sorte à délimiter lesdits espaceurs (25a) dans la couche (25) d'oxyde de silicium.

13. Structure comprenant un transistor bipolaire incluant un collecteur, une base et un émetteur, ladite structure comprenant :
- un substrat (1) semi-conducteur,
- un empilement comprenant successivement à partir du substrat (1) : une première couche (21) électriquement isolante, une seconde couche électriquement isolante (22) en un matériau différent de celui de la première couche électriquement isolante (21) et une couche semi-conductrice (30), ledit empilement comprenant une fenêtre s'étendant jusqu'au substrat (1),
- le collecteur (C), une partie intrinsèque (B1) de la base et l'émetteur (E) étant empilés successivement sur le substrat (1) dans ladite fenêtre, la jonction entre le collecteur (C) et la partie intrinsèque (B1) de la base étant entourée par la seconde couche électriquement isolante (22), la couche semi-conductrice (30) formant une partie extrinsèque (B2) de la base du transistor bipolaire.

14. Structure selon la revendication 13, dans laquelle la deuxième couche (22) électriquement isolante est située sur et en contact avec la première couche (21) électriquement isolante.

15. Structure selon la revendication 13 ou 14, dans laquelle la seconde couche électriquement isolante est en contact direct avec la jonction entre le collecteur (C) et la partie intrinsèque (B1) de la base.

16. Structure selon l'une quelconque des revendications 13 à 15, dans laquelle la première couche électriquement isolante (21) est en oxyde de silicium et la seconde couche électriquement isolante (22) est en nitrure de silicium.

17. Structure selon l'une des revendications 13 à 16, dans laquelle la couche semi-conductrice (30) formant la partie extrinsèque (B2) de la base est en silicium polycristallin.
